Europäisches Patentamt

European Patent Office

Office européen des brevets

(11) Publication number: 0 508 137 A2

# EUROPEAN PATENT APPLICATION

(21) Application number: 92104207.3

(22) Date of filing: 11.03.92

(51) Int. Cl.5: G02F 1/13, H01L 21/60, H01R 23/68

(30) Priority: 11.03.91 JP 70646/91

(43) Date of publication of application:
14.10.92 Bulletin 92/42

(84) Designated Contracting States:
DE IT NL

(71) Applicant: ROHM CO., LTD.
21, Saiin Mizosaki-cho Ukyo-ku
Kyoto(JP)

(72) Inventor: Hirai, Minoru
55-2-308, Kawashima Higashidaicho
Nishikyo-ku, Kyogo(JP)

(74) Representative: Strehl, Schübel-Hopf,
Groening
Maximilianstrasse 54 Postfach 22 14 55
W-8000 München 22(DE)

(54) Liquid-crystal display device and process for producing the same.

(57) The improved liquid-crystal display device has input circuit boards that receive external signals in association with the column and row sides of the liquid-crystal display panel and flexible films typified by TABs on which are mounted ICs that take in signals from said input circuit boards. The lead wires connected to the ICs are such that those connected to one IC are formed on the side of the flexible films which is opposite the side where the lead wires connected to the other IC are formed, and each IC has integrated thereon a drive circuit for outputting drive signals to electrodes on the liquid-crystal display panel. Further, in a completed liquid-crystal display device, the IC mounting sides of the respective flexible films are the same as each other and the respective lead wires are connected to the liquid-crystal panel and the input circuit boards in such a way that those input circuit boards are disposed on the sides of the flexible films which are opposite to said IC mounting sides.

This liquid-crystal display device can be produced by a process in which the output terminals on the input circuit boards are connected to the input pins on the TABs in such a way that the column and row input circuit boards are placed on the reverse side of the respective flexible films whereas the output terminals are connected to the input pins from the obverse side (i.e., where ICs are mounted on the flexible films).

FIG.1(a)

## BAGGROUND OF THE INVENTION:

This invention relates to a liquid-crystal display device and a process for producing the same. More particularly, this invention relates to a structural improvement as regards the mounting of a liquid-crystal panel and the associated drive circuit in a liquid-crystal display device.

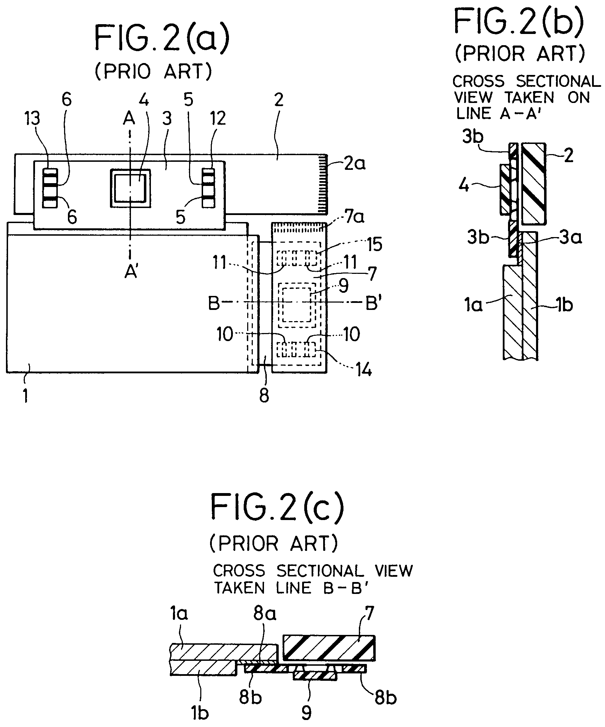

The structure of a prior art liquid-crystal display device is shown in Fig. 2. As Fig. 2(a) shows, the liquid-crystal display device comprises a liquid-crystal display panel 1, a column input circuit board 2 and a row input circuit board 7.

The column input circuit board 2 has a TAB 3 soldered and this TAB which is one of the IC mounting flexible resin films has an IC 4 mouted thereon as an integration of various circuits such as one for driving electrodes on the liquid-crystal display panel 1. The circuit board 2 receives at connector 2a a signal as supplied from an external circuit for driving Y electrodes aligned in the vertical direction of the liquid-crystal display panel 1.

The row input circuit board 7 has a TAB 8 soldered with a similar IC 9 being mounted on it. This circuit board 7 receives at connector 7a a signal as supplied from the outside for driving X electrodes aligned in the horizontal direction of the liquid-crystal display panel 1. Each of TABs 3 and 8 may be used in more than one unit but, for the sake of simplicity, the following description assumes the use of one unit of each TAB.

The liquid-crystal display panel 1 has two panels 1b and 1a; panel 1b is such that part of the transparent electrodes arranged in the vertical direction (in column direction) is exposed at an end, and panel 1a is such that part of the transparent electrodes arranged in the horizontal direction (in row direction) is exposed at an end. Those panels have the liquid crystal held therebetween and are superposed in such a way that their electrode forming sides face each other. The panels may be formed of such substrates as a glass substrate and a plastic film substrate. Part of the electrodes exposed at an end may be coated with a metal. All of such substrates are denoted by the word "panel" in the following description and the appended claims. The substrates are usually provided with a light polarizing plate on the outer surface.

Output pins 3a on the TAB 3 are composed of lead wires spaced on the back side of the film base and their end portions are superposed on the electrodes at the column end portions of panel 1b to be joined to the column electrode forming side of panel 1b (see Fig. 2(b) showing a cross section of Fig. 2(a) taken on line A-A'). Input pins 5 and 6 on the TAB 3 are similarly spaced lead wires which are soldered to the column input circuit board 2.

Output pins 8a on the TAB 8 are also composed of lead wires spaced on the back side of the film base and their end portions are joined to the row electrode forming side of panel Ia (see Fig. 2-(c) showing a cross section of Fig. 2(a) taken on line B-B'). Input pins 10 and 11 on the TAB 8 are similarly spaced lead wires which are soldered to the row input circuit board 7. Each of liquid crystal drive ICs 4 and 9 may be used in more than one unit but, for the sake of simplicity, the present description assumes the use of one unit of each drive IC. In Figs. 2(b) and (c), TABs 3 and 8 are shown to be separate from the input circuit boards 2 and 7, respectively; and this is because those figures show the arrangement before the respective lead wires are soldered to the input circuit boards.

The procedure of connecting the input and output pins on TABs 3 and 8 is described below. First, output pins 3a and 8a on TABs 3 and 8, respectively, are connected to the electrodes at the column and row end portions, respectively, of the liquid-crystal display panel 1. Then, input pins 5 and 6 on TAB 3 (or input pins 10 and 11 on TAB 8) are soldered to the output terminals on the column input circuit board 2 (or row input circuit board 7). Subsequently, the liquid-crystal display device is turned upside down and input pins 10 and 11 on TAB 8 (or input pins 5 and 6 on TAB 3) are soldered to the output terminals on the row input circuit board 7 (or column input circuit board 2). Usually, the resin film forming the TAB 3 (or 8) has a thickness of about 0.1 mm and the liquid crystal drive IC 4 (or 9) has a thickness of about 0.3 - 0.4 mm. Hence, with the liquid crystal drive IC 4 (or 9) being mounted on the film base of TAB 3 (or 8), said IC 4 (or 9) will protrude beyond the film surface of TAB 3 (or 8) and may often bump against the surface of the soldering table. This makes it extremely difficult to solder the input and output terminals on the column input circuit board 2 (or row input circuit board 7) on the side where the liquid crystal drive IC 4 (or 9) is mounted on TAB 3 (or 8) since said circuit board is on the other side of the TAB.

To solve this problem, the prior art involves the step of reversing the liquid-crystal display device in the connecting process. The actual electrode pitch at the column and row end portions is very small and is typically on the order of 0.25 mm (electrode width: 0.125 mm; inter-electrode distance: 0.125 mm). Because of this small pitch, TABs 3 and 8 must be positioned and joined to the liquid-crystal display panel 1 with very close tolerance (i.e., at very high density) and this involves a connecting step separate from the mere soldering step. In addition, an anisotropic conductive adhesive is typically used in this connecting step.

Thus, the prior art process involves the step of reversing the liquid-crystal display device and this is due to the fact that the IC mounting side of TAB 3 is opposite to the IC mounting side of TAB 8. After performing a soldering step on one TAB, the liquid-crystal display device is turned upside down and then a soldering step is performed on the other TAB. Under the circumstances, soldering of input pins 5 and 6 on TAB 3 cannot be accomplished simultaneously with soldering of input pins 10 and 11 on TAB 8. This has been one of the factors that prevent automated production of liquid-crystal display devices. Another problem is a higher chance of the occurrence of poor contact between the liquid-crystal panel and either TAB. When testing the wired liquid-crystal display device for the integrity of electrical connection, the same reversing step is necessary, thereby imparing the testing efficiency.

## SUMMARY OF THE INVENTION:

The liquid-crystal display device of the present invention is characterized by having input circuit boards that receive external signals in association with the column and row sides of the liquid-crystal display panel and flexible films typified by TABs on which are mounted ICs that take in signals from said input circuit boards. The lead wires connected to the ICs are such that those connected to one IC are formed on the side of the flexible films which is opposite the side where the lead wires connected to the other IC are formed, and each IC has integrated thereon a drive circuit for outputting drive signals to electrodes on the liquid-crystal display panel. Further, in a completed liquid-crystal displayed device, the IC mounting sides of the respective flexible films are the same as each other and the respective lead wires are connected to the liquid-crystal panel and the input circuit boards in such a way that those input circuit boards are disposed on the sides of the flexible films which are opposite to said IC mounting sides.

The liqiud-crystal display device of the present invention can be produced by a process in which the output terminals on the input circuit boards are connected to the input pins on the TABs in such a way that the column and row input circuit boards are placed on the reverse side of the respective flexible films whereas the output terminals are connected to the input pins from the obverse side (i.e., where ICs are mounted on the flexible films).

In accordance with the present invention, the connections between the input terminals on one flexible film and the output terminals on the column input circuit board are on the same side as the connections between the input terminals on the other flexible film and the output terminals on the row input circuit board and, hence, connection of the input terminals on the one flexible film can be accomplished in the same step as connection of the input terminals on the other flexible film. Similarly, inspection for the integrity of terminal connections can be accomplished on one and the same side. This obviates the need for producing liquid-crystal display devices or inspecting their electrical connection with the display assembly being reversed as in the prior art. As a result, the present invention will contribute to the purpose of facilitating the efforts to automate the process of fabricating liquid-crystal display devices.

An object, therefore, of the present invention is to provide a liquid-crystal display device that can be manufactured by a process that involves a reduced number of steps and that can be easily automated.

Another object of the present invention is to provide a liquid-crystal display device which, after wiring, can be readily inspected for the integrity of electrical connection with the associated peripheral circuits.

A further object of the present invention is to provide a process for producing a liquid-crystal display device that permits the liquid-crystal assembly to be handled with ease during fabrication and that yet is effectively protected against the occurrence of poor terminal connections.

## BRIEF DESCRIPTION OF THE DRAWINGS:

Fig. 1 is a set of diagrams showing the construction of the liquid-crystal display device of the present invention; and
Fig. 2 is a set of diagrams showing the construction of a prior art liquid-crystal display device.

## DESCRIPTION OF THE PREFERRED EMBODIMENT:

As shown in Figs. 2(b) and 2(c) which are cross-sectional views of a prior art liquid-crystal display device taken on lines A-A' and B-B', respectively, TAB 3 has the same construction as TAB 8, so either one of them is disposed upside down. In Fig. 2, liquid crystal drive IC 9 mounted on TAB 8 is on the same side as film 8b when viewed from output terminals 8a connected to electrodes on the panel 1a and, hence, this IC 9 is unavoidably in a reversed state because those output terminals 8a are connected to electrodes on the panel 1a. In other words, the row input circuit board 7 is on the same side as liquid-crystal panel 1a when viewed from TAB 8. In contrast, the other TAB in the device of the present invention need not be reversed since the associated lead wires are formed on the obverse side. The term "obverse side" as used herein means that side of the film base of each TAB on which the IC is mounted.

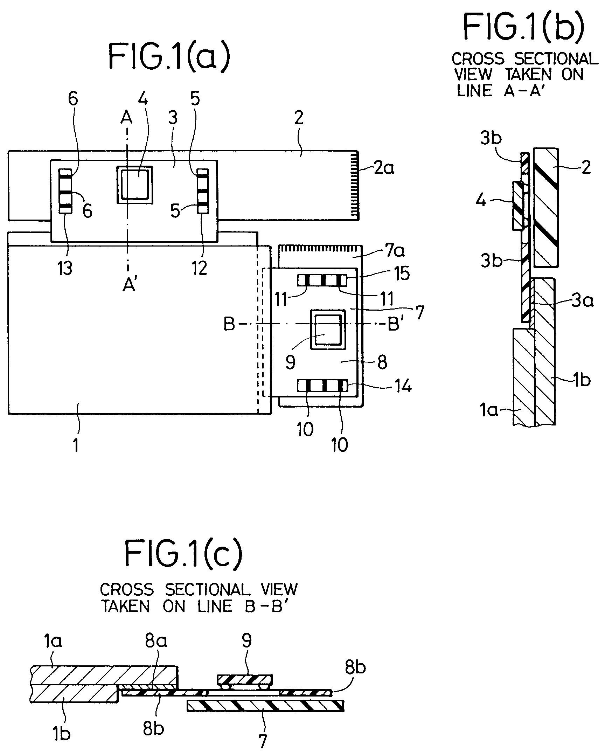

As shown in Fig. 1(c) which is a cross section of the liquid-crystal display device of the preferred embodiment of the present invention as taken on line B-B' of Fig. 1(a), the lead wires on TAB 8 are formed on the obverse side of the film base. Liquid-crystal drive IC 9 is on the side opposite to film 8b as viewed from output terminals 8a connected to electrodes on the panel 1a. It is mounted in such a way that it is positioned on the same side as where the conductor wiring pattern including output terminals 8a are formed. Hence, the row input circuit board 7 can be positioned on the (reverse) side opposite to liquid-crystal panel 1a as viewed from TAB 8. As a result, input terminals 5 and 6 on TAB 3 will be positioned on the same side of the liquid-crystal display device as input terminals 10 and 11 on TAB 8 (i.e., on the obverse side of TAB). This arrangement permits lead wires to be soldered to input circuit boards 2 and 7 on TABs 3 and 8 from the obverse side.

As a result, input terminals 5 and 6 on TAB 3 can be soldered to the output terminals on the column input circuit board 2 in the same step as input terminals 10 and 11 on TAB 8 are soldered to the output terminals on the row input circuit board 7. In other words, the step of reversing the liquid-crystal display unit is obviated. As a further advantage, the completed display unit can be inspected for the integrity of electrical connection from the obverse side.

As in Fig. 2, TABs 3 and 8 are shown to be separate from input circuit boards 2 and 7, respectively, in Fig. 1 since it also shows the arrangement before the respective lead wires are soldered to the input circuit boards.

The process for producing the liquid-crystal display device of the present invention having the construction described above starts with preliminary fabrication of column and row input circuit boards 2 and 7 that have, on their surface, output terminals and connection terminals such as connector 2a for receiving signals supplied from the outside. The respective output terminals are also provided with a solder film while, at the same time, the lead wires to the input sides of TABs 3 and 4 are also provided with a solder film.

Also fabricated preliminarily are TAB 3 that has IC 4 mounted and that has lead wires partly exposed in slits 12 and 13, as well as TAB 8 that has IC 9 mounted and that has lead wires partly exposed in slits 14 and 15. It should be noted that at least one of the TABs 3 and 8 is such that the lead wires serving as input and output pins are formed on the obverse side of the film base whereas the other TAB is such that the lead wires are formed on the reverse side as in the case of the prior art.

Subsequently, the lead wires on the output side of either one of TABs 3 and 8 are connected by means of an anisotropic conductive adhesive to either the column or row electrodes on the liquid-crystal display panel 1, whereas the lead wires on the output side of the other TAB are connected by means of an anisotropic conductive adhesive to either the row or column electrodes on the liquid-crystal display panel 1, whereby a liquid-crystal display unit assembly is fabricated. The output lead wires from TABs must be connected to the column and row electrodes with high precision and, hence, the connection to the column electrodes may be performed in a separate step from the connection to the row electrodes.

On the reverse side of each of the TABs on the liquid-crystal display unit assembly, the prefabricated column input circuit board 2 and row input circuit board 7 are disposed in such a way that the associated output terminals are positioned in alignment with the slits in the respective TABs.

In the last step, the output terminals on the input circuit boards and the input lead wires on the TABs are connected in the associated slits from the obverse (IC mounting) side by means of a soldering/connecting apparatus.

The foregoing description is directed to the case where the input terminals to the column TAB 3 and the row TAB 8 are located on the same side as panel 1a with reference to the surfaces of column input circuit board 2 and row input circuit board 7. Needless to say, the two TABs 3 and 8 may be located on the same side as panel 1b. The foregoing description is also directed to the case where one TAB is provided for both the column and row sides of the liquid-crystal display panel 1. Needless to say, more than one TAB may be provided for either the column or row side of the panel.

Further, the foregoing description is directed to the case where only one input circuit board is provided for both the column and row sides of the liquid-crystal display panel 1. It should, however, be noted that more than one input circuit board may be provided for either the column or row side of the panel. If desired, a single input circuit board which is an integral unit of input circuit boards for the column and row sides may be fabricated and installed on the liquid-crystal display device of the present invention. This will further improve the efficiency of handling input circuit boards. It also goes without saying that the number of input circuit boards need not be identical to the number of TABs.

As described on the foregoing pages, the present invention so much simplifies the fabrication process of liquid-crystal display devices that it can facilitate the accomplishment of automated production of those devices. As a further advantage inspection for the integrity of electrical connection on a wired liquid-crystal display device can be made without turning it upside down.

## Claims

1. In a liquid-crystal display device comprising a liquid-crystal display panel (1) that has a first panel (1b) having a plurality of electrodes arranged in a vertical direction and partly exposed at an end and a second panel (1a) having a plurality of electrodes arranged in a horizontal direction and partly exposed at an end, said panels (1a, 1b) being superposed in such a way that the sides where said electrodes are provided face inwardly, a first circuit board that is connected to said electrodes on the first panel (1b) and that receives a display signal from the outside, and a second circuit board that is connected to said electrodes on the second panel (1a) and that also receives a display signal from the outside, the improvement wherein each of said first and second circuit boards has an input circuit board (2, 7) for receiving external signals and a flexible film (3, 8) carrying an IC (4, 9) for receiving signals from said input circuit board (2, 7), the lead wires (8a) connected to one IC (9) being formed on the obverse side of said flexible film (8) whereas the lead wires (3a) connected to the other IC (4) are formed on the reverse side of said flexible film (3), said ICs (4, 9) having integrated therein drive circuits that output signals for driving the electrodes on said liquid-crystal display panel (1), being further characterized in that the sides of said flexible films (3, 8) where said ICs (4,9) are mounted are the same as each other and part of said lead wires are connected to said liquid-crystal display panel (1) in such a way that said input circuit boards (2, 7) are located on the reverse side opposite to said mounting sides, whereas at least part of the remaining lead wires are connected to said input circuit boards (2, 7).

2. A liquid-crystal display device according to claim 1 wherein said lead wires have input lead wires and output lead wires, further characterized in that the flexible film (3) having lead wires (3a) formed on the reverse side is such that the associated output lead wires are connected to the electrodes on whichever of the first and second panels (1b) that have those electrodes formed on the side facing said reverse side whereas the associated input lead wires are connected to said input circuit boards, and that the flexible film (8) having lead wires (8a) formed on the obverse side is such that the associated output lead wires are connected to the electrodes on whichever of the first and second panels (1a) that have those electrodes formed on the side opposite to said obverse side whereas the associated input lead wires are connected to said input circuit boards.

3. A liquid-crystal display device according to claim 2 wherein each of said flexible films (3, 8) has an opening (12, 13, 14, 15) in which part of said input lead wires are disposed.

4. In a liquid-crystal display device comprising a liquid-crystal display panel (1) that has a first panel (1b) having a plurality of electrodes arranged in a vertical direction and partly exposed at an end and a second panel (1a) having a plurality of electrodes arranged in a horizontal direction and partly exposed at an end, said panels (1a, 1b) being superposed in such a way that the sides where said electrodes are provided face inwardly, a first circuit board that is connected to said electrodes on the first panel (1b) and that receives a display signal from the outside, and a second circuit board that is connected to said electrodes on the second panel (1a) and that also receives a display signal from the outside, the improvement wherein each of said first and second circuit boards has an input circuit board (2, 7) for receiving external signals and a flexible film (3, 8) that is disposed on said input circuit board (2, 7) and that carries an IC (4, 9) for receiving signals from said input circuit board (2, 7), each of said flexible films (3, 8) having formed thereon a plurality of input and output lead wires connected to the terminals of said IC (4, 9), as well as an opening in which part of said input lead wires are disposed, whereas the plurality of lead wires on one of said flexible films are formed on the side which is opposite the side where the plurality of lead wires on the other flexible film are formed, being further characterized in that the sides of said flexible films (3, 8) where said ICs (4, 9) are mounted are the same as each other and said input lead wires are connected to said input circuit boards (2, 7) in said openings (12, 13, 14, 15).

5. A liquid-crystal display device according to claim 4, wherein each of said input circuit boards (2, 7) is provided with connection terminals (2a, 7a) for receiving external signals and output terminals on the obverse side, said output terminals being connected to the input lead wires on said flexible films (3,8) in said openings (12, 13, 14, 15) further characterized in that the flexible film (3) having lead wires (3a) formed on the reverse side is such that the associated output lead wires are connected to the electrodes on whichever of the first and second panels (1b) that have those electrodes formed on the side facing said reverse side whereas the flexible film (8) having lead wires (8a) formed on the obverse side is such that the associated output lead wires are connected to the electrodes on whichever of the first and second panels (1a) that have those electrodes formed on the side opposite to said obverse side.

6. A liquid-crystal display device according to claim 5, wherein one of said flexible films (3, 8) corresponds to the column electrodes on the liquid-crystal display panel (1) and the other flexible film corresponds to the row electrodes on said panel (1), said flexible films (3, 8) being two or more in number.

7. A liquid-crystal display device according to claim 6, wherein said flexible films (3, 8) are TABs.

8. In a process for producing a liquid-crystal display panel that comprises a liquid-crystal display panel that has a first panel (1b) having a plurality of electrodes arranged in a vertical direction and partly exposed at an end and a second panel (1a) having a plurality of electrodes arranged in a horizontal direction and partly exposed at an end, said panels (1a, 1b) being superposed in such a way that the sides where said electrodes are provided face inwardly, a first circuit board that is connected to said electrodes on the first panel (1b) and that receives a display signal from the outside, and a second circuit board that is connected to said electrodes on the second panel (1a) and that also receives a display signal from the outside, the improvement wherein each of said first and second circuit boards has an input circuit board (2, 7) for receiving external signals and a flexible film (3, 8) that carries on the obverse side an IC (4, 9) that is connected to said input circuit board (2, 7) for receiving a signal therefrom and outputting a drive signal for display, one of said flexible films (3) is such that the input and output terminals on said IC (4) are connected to a plurality of input and output lead wires (3a) that are provided on the reverse side of said film (3) whereas the other flexible film (8) is such that the input and output terminals on said IC (9) are connected to a plurality of input and output lead wires (8a) that are provided on the obverse side of said film (8), said process comprising:

the step of connecting the output lead wires on one of said flexible films (3) to the electrodes on the first panel (1b) while connecting the output lead wires on the other flexible film (8) to the electrodes on the second panel (1a);

the step of disposing said input circuit boards (2, 7) on the reverse side of said respective flexible films (3, 8); and

the step of connecting, from said obverse side, the respective input lead wires on said flexible films (3, 8) to said output terminals on said input circuit boards (2, 7).

9. A process according to claim 8 wherein each of said flexible films (3, 8) has an opening (12, 14) in which part of said input lead wires are disposed, and the input lead wires on the respective flexible films (3, 8) are connected from the obverse side in positions corresponding to said openings.

10. A process according to claim 9 wherein said flexible films (3, 8) are TABs which are two or more in number, the output lead wires on one TAB being connected by means of an anisotropic conductive adhesive whereas the input lead wires on the other TAB being connected by soldering.

11. In a liquid-crystal display device comprising a liquid-crystal display panel (1) that has a first panel (1b) having a plurality of electrodes arranged in a vertical direction and partly exposed at an end and a second panel (1a) having a plurality of electrodes arranged in a horizontal direction and partly exposed at an end, said panels (1a, 1b) being superposed in such a way that the sides where said electrodes are provided face inwardly, a first circuit board (2) that is connected to said electrodes on the first panel (1b) and that receives a display signal from the outside, and a second circuit board (7) that is connected to said electrodes on the second panel (1a) and that also receives a display signal from the outside, the improvement wherein each of said first and second circuit boards has a flexible film (3, 8), wherein lead wires (8a) are formed on the obverse side of one flexible film (8) and lead wires (3a) are formed on the reverse side of said other flexible film (3), being further characterized in that at least part of said lead wires (3a, 8a) are connected to said liquid-crystal display panel (1) in such a way that said input circuit boards (2, 7) are located on the reverse side opposite to said mounting sides.

## FIG.1(a)

## FIG.1(b)
CROSS SECTIONAL VIEW TAKEN ON LINE A-A'

## FIG.1(c)
CROSS SECTIONAL VIEW TAKEN ON LINE B-B'

# FIG.2(a)
(PRIO ART)

# FIG.2(b)
(PRIOR ART)

CROSS SECTIONAL
VIEW TAKEN ON
LINE A – A'

# FIG.2(c)
(PRIOR ART)

CROSS SECTIONAL VIEW
TAKEN LINE B – B'